# EUROPEAN PATENT SPECIFICATION

(11) **EP 1 606 431 B1**
(45) Date of publication and mention of the grant of the patent: **13.08.2008**
(21) Application number: 04720872.3
(22) Date of filing: 16.03.2004
(51) Int. Cl.: C23F 1/18, C23F 3/06, H01L 21/3213

(54) **SOLUTION FOR ETCHING COPPER SURFACES AND METHOD OF DEPOSITING METAL ON COPPER SURFACES**
LÖSUNG ZUM ÄTZEN VON KUPFEROBERFLÄCHEN UND VERFAHREN ZUR ABSCHEIDUNG VON METALL AUF KUPFEROBERFLÄCHEN
SOLUTION POUR GRAVER DES SURFACES DE CUIVRE ET PROCEDE DE DEPOT DE METAL SUR DES SURFACES DE CUIVRE

(30) Priority: 25.03.2003 DE 10313517
(43) Date of publication of application: 21.12.2005
(73) Proprietor: ATOTECH Deutschland GmbH, 10553 Berlin (DE)
(72) Inventor: MAHLKOW, Hartmut, 12159 Berlin (DE); SPARING, Christian, 13509 Berlin (DE)
(74) Representative: Patentanwälte Bressel und Partner
(86) International application number: PCT/EP2004/002702
(87) International publication number: WO 2004/085706

(56) References cited:
- EP-A- 0 926 265
- EP-A- 1 167 482
- EP-A- 1 167 585
- WO-A-98/15674
- DE-A- 2 149 196
- FR-A- 2 392 100
- GB-A- 1 546 524
- US-A- 6 036 758
- PATENT ABSTRACTS OF JAPAN vol. 0071, no. 67 (C-177), 22 July 1983 (1983-07-22) -& JP 58 073775 A (NIPPON PEROXIDE KK), 4 May 1983 (1983-05-04)

## Description

The invention relates to a method of manufacturing a solution for etching copper or a copper alloy. The solution serves to produce circuit carriers, more specifically printed circuit boards, or is suitable for the semiconductor technique, as well as to produce leadframes and contacts such as e.g., multipoint connectors and contacts In switches, plug and socket connectors, sockets and plugs.

During the manufacturing of circuit carriers, copper surfaces are treated, *inter alia,* with an etch solution to remove contaminants on the surface or to prepare them for the treatment that Is to follow. One thereby aims at removing from 1 - 2 *µ*m copper. In the following treatments, organic or metal layers are then applied. These layers may perform different functions. Metal layers for example can form solderable or bondable regions or serve as an etch resist. Depending on the purpose they serve, these layers may remain either permanently or temporarily on the copper surface.

In any event, in order to prevent parts of the surface layer from stripping or chipping off, it is necessary that a strong adherent bond forms between the treated copper surface and the layer to be applied.

In the manufacturing of semiconductors, the phenomenon of epoxy bleed out could be observed at the surface of leadframes, said phenomenon occurring for example after the chip has been resin coated, when the excess epoxy resin leaks ("bleeds out") onto the external contacts of the leadframe. These sites are then lost to electroplating.

In practice, known etch solutions for slightly etching copper surfaces in view of a metallization to follow often consist of aqueous solutions of alkali peroxodisulfate or of hydrogen peroxide, each combined with sulfuric acid. These etchants permit to achieve etch textures with residual roughness of 1 - 2 *µ*m which results in a size increase of the surface of up to 50 % as compared to the geometrical surface. This surface increase is due to the coarse copper texture obtained.

Further known copper etchants are iron(III) salts, hypochlorite and copper(II) salts in an aqueous acidic or alkaline solution; however, these are hardly considered for the application described herein above because their etch effect is too strong, which makes them more suited for use for differential etching or for completely removing copper on base material. In these applications, the undercuts (steepness of the slope of the conductor lines for example) must be considered, whereas in these cases the etch textures are not important. The etch resist must be prevented from being attacked and it must be possible to regenerate the etch solution (copper recovery) without any problem.

The composition of the etch solution depends, *inter alia,* on the type of layer to be applied thereon. Metallic and organic layers for example pose different demands on the structure and quality of the copper surface.

Metallic bright copper surfaces are not considered to be suited for being subsequently coated with organic coatings such as photoresists or solder resist masks nor are they suited for press-laminating multilayers. For this reason, modified etchants are used to roughen the copper and to simultaneously form a brown-black copper(I)/copper(II) oxide film. The adhering layers of the photoresists and the solder resist masks or of epoxy resin can become anchored in said oxide film during press-laminating (U.S. Patent No. 6,036,758; EP 0 442 197 A2; EP 0 926 265 A1). Said etchants contain mineral acids, alkane sulfonic acids, mixtures of the acids mentioned, inhibitors and known oxidizing agents and are intended to oxidize and roughen smooth copper areas. They are not suited for subsequent metallization though.

The increasing miniaturization of circuit carriers, and more specifically miniaturization in semiconductor processing, calls for new solutions. Wet processes, more specifically electroplating processes, such as copper plating and the manufacturing of copper conductors on microchips are finding increasing acceptance in this technical field. In this field, the surfaces are required to be polished and bright, an essential prerequisite for obtaining fine circuit structures. These polished surfaces can be produced using what are termed etch (polishing) solutions. Such type solutions are known from EP 1 167 585 A2, U.S. Patent Application No. 2002/0022370 and US RE 37,786 E and result in high polish copper surfaces.

Apart from the oxidizing agent, hydrogen peroxide or alkali peroxodisulfate, the composition and effect of these etch (polishing) solutions considerably differ from the etch solutions mentioned herein above. In addition to considerable amounts of abrasive substances (silicon dioxide - aluminum dioxide - ceroxide - zirconium dioxide) included for increasing the removal rates, the solutions are disclosed to contain viscosity increasing agents (polyalcohols, polyethylene glycols, etc.), organic acids (amino acetic acid, amido sulfuric acid, oxalic acid, citric acid, gluconic acid), inorganic acids and inhibitors (N-methyl formamide, benzotriazole, imidazole, phenacetine, thiourea, mercaptobenzothiazole).

Moreover, the pH of the solutions varies from slightly acid to strongly alkaline (9 - 14, 3 - 10, 5 - 8) thus clearly exceeding that of current etchants. The solutions mentioned also serve to etch, slightly etch or level copper surfaces, with only low removal rates of from 0.03 to 0.1 µm being expected for polishing in accordance with the intended purpose. Higher removal rates may for example be achieved by increasing the temperatures and by adding abrasive substances. In this case however, the amount of added complexing agents has to be increased in order to keep the oxidized copper in solution as oxidized copper, because of the high pH of the solution, can only be kept in solution using complexing agents such as EDTA or NTA for example. If the etch solution contains too much copper, it cannot be used any longer.

DE-OS 21 49 196 discloses an aqueous solution for etching copper or a copper alloy, the solution comprising peroxodisulfate and at least one heterocyclic azol compound. Further this solution may also contain one or more halides and sulfuric acid or phosphoric acid. This solution is intended to be used for etching copper on printed circuit board material.

DE 100 34 022 A1 discloses an acid treatment solution for copper surfaces, the solution comprising hydrogen peroxide, at least one five-membered heterocyclic compound, such as a tetrazol, and at least one microstructuring agent, this agent being selected from the group comprising organic thioles, sulfides, disulfides and thioureas. The solution may further contain an acid, sulfuric acid for example. The copper surfaces produced by a treatment with this solution have a microstructure having two roughness values, the first one being in the range of from 1 to 10 µm and the second one being in the range of from 50 to 500 nm. The solution is intended to be used for the manufacture of printed circuit boards.

U.S. Patent No. 6,036,758 describes an etch solution for the surface treatment of copper that comprises hydrogen peroxide and an aromatic sulfonic acid or a salt thereof. In addition, this etch solution includes, *inter alia,* an inorganic acid, with sulfuric acid comprised in a range between 2 and 20 % (w/v) being preferred, a concentration between 5 and 10 % (w/v) being particularly preferred.

EP 1 167 482 A2 discloses an etch (polishing) solution comprising an N-heterocyclic compound, hydrogen peroxide and a salt of the dodecyl benzene sulfonic acid. The solution is suited for manufacturing integrated circuits, the excess wiring material being intended to be etched away after the metal plating step. In addition to the constituents mentioned, abrasive substances and additives such as sulfuric acid for example, may be added to the etch (polishing) solution. The removal rate is a function of the pH, the temperature and the kind and strength of the acids used. The solution operates at a pH of between 5 and 12.

FR-A 2 392 100 relates to a solution for selective etching of copper on printed circuit boards. This solution contains a mineral acid, such as phosphoric acid, an oxidant, such as hydrogen peroxide, a stabilizer for the oxidant, such as phenolsulfonic acid, and a solvent, such as water. The concentration of phenolsulfonic acid may be 10 to 80 g/l.

GB-A 1 546 524 describes a stabilized etch solution for etching metals, copper for example. The solution comprises an acid solution of an oxidant combination of a peroxide and molybdenum. The oxidant may be hydrogen peroxide. The solution may contain hydrochloric acid or sulfuric acid and further phenolsulfonic acid as the stabilizer. In one embodiment hydrochloric acid is used. This etch solution contains 20 g/l phenolsulfonic acid.

In the printed circuit board technique, miniaturization poses new demands on the surfaces, more specifically on the copper surfaces, which may for example form the basis for end layers such as electroless nickel-gold, chemical tin, silver, palladium and combinations of the metals mentioned. For forming fine circuit structures, the surfaces produced must provide good bonding for subsequent metallization.

Bonding strength is determined, *inter alia,* by the surface structure of the etched copper, whereby it is assumed that the achieved bonding strength will be the greater the coarser the surface structure of the copper surface is. As a result, It Is expected that bright copper surfaces will have a reduced bonding strength.

It partially appeared that the use of the etchants mentioned herein above tends to cause problems during metal deposition, for example during electroless deposition of copper, tin, silver, nickel, gold, palladium and bismuth. These problems are that in some cases the metals mentioned could not deposit at all and that In some other cases but a very non-uniform metallization could be obtained.

However, defect bondings of the metal layers to be applied do not allow to dispense with slightly etching the copper.

In the course of the tests performed with etchants that produce bright copper surfaces, it has been found out that these suffer from considerable shortcomings. After etching, dark brown stains form on the substrate being taken to the rinse tank, said stains being dull once they have been dipped in sulfuric acid. The operating range of the etchants is very narrow, adding tremendous expense to the analysis of the bath to be operated.

Using the known methods and processing solutions, it is therefore not possible to concurrently meet the following requirements:
i) Providing metal layers with sufficient bonding strength, even on very narrow copper conductors that are applied to substrates, such as printed circuit board material, leadframes or various contacts. This requirement is intended to prevent the metal deposits from chipping off or from being otherwise stripped off.
ii) Providing a copper surface as bright as possible for the metallization to follow, in particular In order to permit formation of very fine circuit structures.
iii) Ensuring sufficient process safety as the substrate is being taken to the rinse tank so that dark brown stains are prevented from forming on the copper surface.

Besides these requirements, the etched surfaces on the leadframes are intended to additionally minimize the formation of resin smear as a result of the observed epoxy bleed out or to largely prevent said resin smear from contaminating the external contacts. Furthermore, the etchants are intended to be affordable and easy to handle.

Therefore the basic object of the present invention is to meet the requirements mentioned In order to overcome the drawbacks of the known solutions and methods. More specifically, it is intended to produce the brightest possible copper surface.

The solution to these problems is achieved by the method of manufacturing a solution for etching copper or a copper alloy in accordance with claim 1.

Preferred embodiments of the Invention are recited in the subordinate claims.

The solution manufactured with the method in accordance with the Invention serves to etch copper or a copper alloy on substrates, preferably on electric circuit carriers, more specifically on printed circuit boards or in the semiconductor technique, as well as to produce leadframes and contacts such as *e.g.,* multipoint connectors and contacts in switches, plug and socket connectors, sockets and plugs. The etch solution preferably serves to produce a copper surface that is suited for being subsequently coated with metals. The solution manufactured with the method in accordance with the invention is a solution having a pH of about 4 and lower. It does not contain sulfate ions. It comprises:
a) at least one oxidizing agent, selected from the group comprising hydrogen peroxide and peracids, and
b) at least one substance, selected from the group comprising aromatic sulfonic acids and salts of the aromatic sulfonic acids.

Due to their manufacturing method, organic and especially aromatic sulfonic acids have residual concentrations in sulfate ions. This is due to the fact that the sulfonic acids are subject to hydrolysis thus forming the respective non-sulfonated aromatic compounds and sulfate ion. This reaction is the reversal of the sulfonation reaction. Therefore aromatic sulfonic acids are always accompanied by sulfate ions (Ullmanns Encyclopädie der technischen Chemie [Ullmann's encyclopedia of technical chemistry], 4th edition, volume 8, pages 412-416). Especially aromatic sulfonic acids that contain a group, such as a nitro radical, in a meta-position at the aromatic ring are preferably subject to such hydrolyzation. In particular this applies to *m*-nitrobenzenesulfonate which is *expressis verbis* mentioned in U.S. Patent No. 6,036,758 for its use as an additive to a composition useful for the surface treatment of copper. Therefore it is considered that the solutions disclosed in this document are not free of sulfate as required according to the present invention.

Hereto before, the circumstance that aromatic sulfonic acids contain sulfate ions has generally been disregarded because, for etching, sulfonic acids are often used precisely together with sulfuric acid. It has however been found out that bright copper layers can only be obtained with sulfate free sulfonic acid in combination with the other constituents of the solution manufactured with the method in accordance with the invention.

By the sulfate ion free solution manufactured with the method in accordance with the Invention a solution is meant that has a sulfate ion concentration of less than 0.2 % (w/v). Further, the concentration of sulfate ion in the solution is that concentration established if sulfate ion is brought into the solution by adding sulfate containing sulfonic acid or the salt thereof to be used in accordance with this Invention to the solution wherein the sulfate ion concentration in the sulfonic acid or the salt thereof is less than 0.2 % (w/v). In both definitions of sulfate free solution sulfate ion may originate from sulfonic acid, the salt thereof and/or from any other source.

For quantification of the concentration of sulfate ion in a sulfonic acid or in the salt thereof or in the etch solution, known methods may be utilized such as ion chromatography or the method for gravimetric determination of sulfate ion as the barium sulfate. If the concentration of sulfate ion in the solution is higher than the value given above, its concentration must be reduced to less than this value, for example by precipitating sulfate Ion as barium sulfate by using barium chloride. The aromatic sulfonic acids themselves do not form hardly soluble barium salts. Therefore the aromatic sulfonic acids do not precipitate and sulfate can be easily separated from the solution. During the use of such solution, for maintaining the solution free of sulfate, the solution may be regenerated with a barium salt solution, e.g. a solution of barium carbonate. Such regeneration may be performed by subjecting the solution to a barium salt solution In a batch operation. Alternatively regeneration can also be performed continuously by adding the barium salt In a small excess to the solution according to the Invention In order to continuously remove sulfate thereof by precipitation.

The method for depositing metal to the surface of copper or a copper alloy is simple, easy to perform and cheap. It serves to prepare the copper or copper alloy surface to thereafter deposit metal to this surface, especially of a copper or copper alloy layer applied to a substrate. It involves the following method steps:
a) contacting the surface with the solution manufactured with the method in accordance with the invention and thereafter
b) coating the surface with at least one metal.

The substrates comprising copper surfaces more specifically include electric circuit carriers, leadframes and contacts such as e.g., multipoint connectors and contacts in switches, plug and socket connectors, sockets and plugs.

The solution manufactured with the method in accordance with the invention has a micro-etching effect. At 23°C, the etch rate is on the order of 1 - 2 µm per minute. The solution permits to obtain an excellent quality, oxide free, smooth, salmon-pink copper surface with a satin to bright finish. This appearance is due to the obtained very small copper crystals that form a uniform microstructure on the surface of the metal, thus being responsible for the superior optical appearance. The microstructure of metal surfaces may for example be analyzed using Atomic Force Microscopy (AFM), which concurrently permits to determine the residual roughness of the surface. AFM measurements rely on measuring the strength and contributions of interparticular interactions such as Van der Waals interactions or electrostatic interactions and permit to image surface structures at the atomic level. They show that, after using the etch solution, a residual roughness Rₘₐₓ of 26 nm was achieved. As compared to the geometrical area, the surface only Increased by 3.6 % (measured on 10 *µ*m by 10 *µ*m areas).

It has been found out that the values obtained for the residual roughness are well correlated with the optical appearance of the metal surface. Table 1 opposes the values obtained for the residual roughness and the optical appearance.

**Table 1:**

| Residual roughness Rₘₐₓ[nm] | Optical Appearance |
|---|---|
| < 40 | bright finish |
| 41-50 | satin to bright finish |
| 51-79 | satin finish |
| > 80 | matte |

Moreover, it has been found out that the residual roughness depends on the acidic strength of the etch solution. It can be noted that higher acidic strength leads to greater residual roughness and, as a result thereof, to a greater Increase of the surface and vice versa. The acidic strength may also Influence the etch rate which In turn affects the residual roughness with higher etch rates usually resulting In comparatively greater residual roughness. In view thereof, it has also been found out that the etch rate is not the sole factor responsible for the formation of surfaces having the brightest possible finish. It was clearly to be seen that the use of the more specifically sulfate free etch solution produced, even at the same etch rate, a significantly enhanced appearance *i.e.,* a surface with a brighter finish.

The solution for etching copper or a copper alloy and the method for depositing metal to the surface of copper or a copper alloy permit to eliminate the problems arising using the known means. The bright surfaces required as a result of the ever-increasing miniaturization can be produced with the etch solution without the trade-off of a simultaneous reduction of bonding strength of the metallization to follow. There is no formation of brown stains on the bright surface while the substrate is being taken to the rinse tank, which additionally further improves the bonding strength.

Surprisingly, resin smear, which may form on the areas of contact of leadframes as a result of "epoxy bleed out" as they are being cast in plastic, may be minimized using the solution manufactured with the method in accordance with the invention prior to electrolytically coating with solder metal.

Another advantage of a metallic bright surface showing no stains Is that one avoids the problems stemming from a matte and/or stained surface during adjustment of a photomask on the conductive pattern. Adverse effects during the following metal plating step, for example during electroless deposition of bismuth, copper, tin, silver, nickel, gold or palladium are not observed.

The solution manufactured with the method in accordance with the Invention also permits to overcome the problem arising using known solutions, the problem being that In some cases there Is no metal deposit at all though the surface has previously been etched with the etch solution or that the deposit obtained is non-uniform. These problems arising using the known etch solutions are due to the fact that the copper surfaces produced have too coarse a structure *i.e.,* too high roughness depth values. If one assumes for example that the copper surfaces have a roughness depth of 1 - 2 *µ*m, the subsequent layers to be formed thereon, which usually have a thickness of 0.2 - 5 *µ*m, will adapt to the given texture. The epitaxial effects resulting from the structure can be demonstrated. They negatively affect corrosion behavior of chemically deposited nickel for example. For the reasons mentioned, surfaces that are etched in this manner are not suited for producing fine circuit structures.

The resulting copper removal Is low so that after etching the thickness of the copper layer varies within but a narrow range. Another advantage is the low pH of the solution, which is 4 or less, as such a pH permits, in contrast to many prior art etch (polishing) solutions, to utilize the solution while using alkaline soluble solder resists. The service life *i.e.,* the copper absorption of such an etchant without the trade-off of a reduction of the brightness of the copper surfaces, is on the order of 20 g/l and more, which is also due to the low pH without complexing agents having to be added to the solution. The operation of the bath, the analyses and the necessary replenishments are easy to perform.

The solution manufactured with the method in accordance with the invention has a pH on the order of 4 and less, preferably of 3 and less. A pH ranging from 2.2 to 1.8 is particularly preferred.

In order to achieve the etching effect of the solution manufactured with the method of the invention as it has been described, the aromatic part of the aromatic sulfonic acids and of the salts of the aromatic sulfonic acids preferably comprises at least one phenyl group, which may be substituted by one or more radicals selected from the group comprising nitro, amino, hydroxy, halogen, C₁ - C₅-alkyl radicals and C₁- C₅-alkoxy radicals. The alkyl and alkoxy radicals may also be substituted, preferably by amino, hydroxy and/or halogen. If the phenyl group is substituted by a plurality of radicals, these may be selected independently from one another. Compounds which are selected from the group comprising benzene sulfonic acid, phenol sulfonic acid, toluene sulfonic acid and amino benzene sulfonic acid are particularly preferred. Naphthalene sulfonic acid is another preferred substance. The aromatic sulfonic acids of particular preference are such having a comparatively low acidic strength.

The solution may further preferably contain at least one N-heterocyclic compound. The N-heterocyclic compounds are preferably selected from the group comprising mono-N, di-N, tri-N and tetra-N heterocyclic compounds. More specifically, the compounds may thereby have 5 or 6 members. Compounds of the group comprising pyridine, N-methyl pyrrolidone, adenine, guanine, uric acid, Imidazole, pyrazole, piperazine, pyrrolidone, pyrroline, triazole, tetrazole and the derivatives thereof are preferably suited.

The N-heterocyclic compounds contained in the etch solution do not substantially influence the etch rate of the solution.

The preferred concentration ranges of the solution constituents are as follows:
aromatic sulfonic acids and the salts of the aromatic sulfonic acids:
   preferably from 2 to 250 g/l,
   more preferably from about 20 to about 60 g/l,
N-heterocyclic compounds:
   preferably from 0.1 to 300 g/l,
   more preferably from about 10 to about 80 g/l,
hydrogen peroxide (35 % (w/v)):
   preferably from about 60 to about 110 g/l,
   more preferably from about 80 to about 100 g/l,
   most preferably about 100 g/l.

It is to be understood that the etch solution also operates outside of the concentration ranges Indicated. Accordingly, the concentration ranges indicated are mere standard values.

The peracids used are selected from the group comprising organic and inorganic peracids, said peracids being preferably selected from the group comprising perboric acid and perbenzoic acid.

In addition to the constituents mentioned, the solution manufactured with the method in accordance with the invention may comprise at least one adjuvant selected from the group comprising polyethylene glycol, polypropylene glycol and the derivatives thereof. It could be observed that, by adding this adjuvant, the copper crystals became even smaller, which additionally minimizes the size Increase of the surface, thus further reinforcing the bright finish of the surface treated. Said adjuvants preferably have a degree of polymerization In the range of from about 100 to about 1000.

According to the method for depositing metal to the surface of copper or a copper alloy the copper surfaces are preferably cleaned prior to being treated with the solution manufactured with the method in accordance with the invention in order to remove from the copper surface contaminations that would interfene with the treatment. Conventional acidic cleaning fluids may be utilized. Usually, surfactants and, If need be, complexing agents such as triethanolamine are added to the aqueous cleaning fluids In order to improve the cleaning effect.

Preferably, a rinse step with deionized water for example may be provided for after cleaning.

Then, the copper surfaces are treated with the solution manufactured with the method in accordance with the invention, said solution being preferably operated in the method at a temperature of from about 20°C to about 60°C. The processing time preferably amounts to from about 10 sec to about 400 sec. The higher the temperature of the solution during etching, the faster the etch reaction will proceed. Accordingly, a shorter processing time is needed In this case to obtain a certain etch result. For technical reasons, an etch temperature ranging from about 20 to about 25°C is preferred to keep easy control of the method, with the preferred processing time being about 120 sec.

Next, the copper surfaces can be contacted with sulfuric acid, more preferably with 1 % (w/v) sulfuric acid. Prior to metal plating, the surfaces can preferably be rinsed, more specifically using deionized water. The metal deposited is preferably selected from the group comprising bismuth, copper, tin, gold, silver, palladium and nickel, with the metal being more preferably formed as electroless nickel-gold or as chemical tin.

The metal layers applied may for example serve as bondable and solderable contact areas or as electrical contact layers for push buttons or plug contacts. The metal layers may for example be deposited by electrochemical, electroless or chemical plating. Chemical deposition by metal to metal charge transfer is preferred, one metal (here copper or a copper alloy) dissolving partially while the dissolved metal, chemical tin for example, is deposited. Electroless plating e.g., electroless nickel-gold is also preferred.

For forming an electroless nickel-gold layer, the copper surface is first treated with a bath by means of which palladium nuclei are deposited onto the surface. Next, metal plating may be performed In another bath comprising nickel ions, for example In the form of a sulfate salt, and a reducing agent. Usually, the reducing agent utilized is a hypophosphite salt, for example the sodium salt thereof, or the corresponding acid thereof. In this case, a nickel-phosphorus layer forms. If a nickel-boron coating is to be generated, the reducing agent utilized will be a borane, for example dimethylamine borane or a boranate such as sodium boron hydride. If pure nickel layers are to be deposited, the reducing agent used will preferably be hydrazine or a derivative thereof. These baths additionally comprise complexing agents, more specifically organic carboxylic acids, pH adjusting agents such as ammonium hydroxide or acetate, as well as stabilizers such as sulfur compounds or lead salts. The gold layer is applied to the electroless plated nickel layer, for example by a charge transfer method or by electroless plating, *i.e.,* using a reducing agent.

For forming a chemical tin layer, the copper surface is contacted with a solution comprising tin(II) ions, for example tin(II) sulfate, an acid such as sulfuric acid, and a thiourea derivative. The tin layer is formed on the copper surface via a charge transfer reaction, with copper dissolving to the benefit of tin.

The substrates comprising the copper surfaces can be processed in current dip plants. For the processing of printed circuit boards, it has been found out that the utilization of what are termed conveyorized plating lines in which the printed circuit boards are conveyed through the plant on a horizontal conveying direction (path) while being contacted with the processing fluids via suited nozzles such as spray or flow nozzles is particularly advantageous. For this purpose, the printed circuit boards can be held horizontally or vertically or in any other orientation.

In a similar fashion, substrates comprising copper surfaces such as leadframes can be processed in reel-to-reel (RTR) systems.

### The following examples serve to further explain the invention:

Except for Comparative Example 4a, the concentration of the sulfate ions in all of the etch solutions of the examples described was reduced to a value that corresponds to a concentration of sulfate ion in the sulfonic acid of less than 0.2 % (w/v) which is added to the solution. This was achieved by means of barium sulfate precipitation. The barium sulfate thus obtained was filtered away.

The pH in the solutions manufactured with the method according to the present invention was always about 4 or less.

In the examples, printed circuit boards that were electrolytically reinforced with copper cladding were processed in the following manner.
1. Cleaning in an acidic, conventional cleaning fluid;
2. Rinsing In water,
3. Processing the printed circuit boards for 2 minutes each (see examples);
4. Dipping into a 1 % (w/v) sulfuric acid;
5. Rinsing in water;
6. Metal plating with electroless Ni/P and then with chemical gold using current metal plating solutions.

### Example 1a - Example In accordance with the invention:

An aqueous solution was prepared by mixing the following constituents:

| | |
|---|---|
| phenol-4-sulfionic acid (sulfate free) | 50 g |
| hydrogen peroxide 35 % (w/v) | 100 g |

Deionized water was added to bring the volume to 1 L.

The solution was heated to 23°C. Then, two copper foils (printed circuit board quality) were each treated according to the aforementioned method scheme by dipping them for 120 sec Into the solution. After treatment with warm deionized water, they were dried. One foll was used to determine the residual roughness while the other foil was metal plated In compliance with the method scheme.

The copper layer of the analyzed foil had a satin to bright finish and had a residual roughness of 44 nm. No stains formed while it was taken to the rinse tank. The etch rate was 0.66 *µ*m/mln. After tin plating, an adherent bond between the copper surface and the applied tin layer could be observed.

### Example 1b - Example in accordance with the invention:

Example 1 a was repeated using a solution with the following composition:

| | |
|---|---|
| toluene-4-sulfonic acid (sulfate free) | 25 g |
| hydrogen peroxide 35 % (w/v) | 100 g |

Deionized water was added to bring the volume to 1 L.

The copper layer had a satin finish and a residual roughness of 63 nm. No stains formed while it was taken to the rinse tank. The etch rate was 2.0 *µ*m/min. After silver plating, a sufficiently adherent bond between the copper surface and the applied silver layer could be observed.

As mentioned herein above, it appeared that the etch rate is a function of the acidity of the acid used as can be seen from the Examples 1 a and 1 b. Phenol-4-sulfonic acid has a lower acidity and accordingly had a much lower etch rate than toluene-4-sulfonic acid. This, together with the formation of smaller copper crystals, resulted in a reduced residual roughness in Example 1 a.

### Example 2 - Example in accordance with the invention:

Example 1 b was repeated using a solution with the following composition:

| | |
|---|---|
| toluene-4-sulfonic acid (sulfate free) | 25 g |
| hydrogen peroxide 35 % (w/v) | 100 g |
| polyethylene glycol (degree of polymerization: 100 - 400) | 25 ml |

Deionized water was added to bring the volume to 1 L.

The copper layer had a satin to bright finish and had a residual roughness of 43 nm. No stains formed while it was taken to the rinse tank. The etch rate was 1.8 *µ*m/min. After nickel plating, an adherent bond between the copper surface and the applied nickel layer could be observed.

By adding polyethylene glycol in Example 2, one obtained a reduced etch rate and, as a result thereof, a reduced residual roughness when directly compared with Example 1 b.

### Example 3 - Example in accordance with the Invention:

Example 1b was repeated using a solution with the following composition:

| | |
|---|---|
| toluene-4-sutfonic acid (sulfate free) | 25 g |
| hydrogen peroxide 35 % (w/v) | 100 g |
| pyridine | 30 ml |

Deionized water was added to bring the volume to 1 L.

The copper layer was bright and had a residual roughness of 31 nm. No stains formed while it was taken to the rinse tank. The etch rate was 1.5 *µ*m/min. After electroless palladium plating, an adherent bond between the copper surface and the applied palladium layer could be observed.

The solution manufactured with the method in accordance with the invention was prepared, using the same sulfonic acid as In Example 1b and adding an N-heterocycllc compound. As compared to Example 1b, the etch rate diminished and the size of the copper crystals was strongly reduced. As a result, the residual roughness dropped significantly and the surface accordingly had a uniform bright appearance.

### Comparative Example 4a:

Example 1a was repeated using a solution with the following composition:

| | |
|---|---|
| benzene sulfonic acid (containing about 2 % (w/v) H₂SO₄) | 25 g |
| hydrogen peroxide 35 % (w/v) | 100 g |
| pyridine | 30 ml |

Deionized water was added to bring the volume to 1 L.

The copper layer was matte and had a residual roughness of 88 nm. No stains formed while it was taken to the rinse tank. The etch rate was 1.2 *µ*m/mln at a temperature of 25°C. After bismuth plating, an adherent bond between the copper surface and the applied bismuth layer could be observed.

Here it appeared that, although the etch rate was low, the surface that formed was not bright The etch texture could not be improved by adding an N-heterocyclic compound. This example permitted to demonstrate the influence of a sulfonic acid comprising sulfate ions that was not In accordance with the present invention. The solution behaved like a sulfuric acid etch solution.

### Example 4b - Example In accordance with the Invention:

Comparative Example 4a was repeated using a solution with the following composition:

| | |
|---|---|
| benzene sulfonic acid (sulfate free) | 25 g |
| hydrogen peroxide 35 % (w/v) | 100 g |
| pyridine | 30 ml |

Deionized water was added to bring the volume to 1 L.

The copper layer had a satin to bright finish and had a residual roughness of 45 nm. No stains formed while it was taken to the rinse tank. The etch rate was 1.3 *µ*m/min. After chemical gold plating, an adherent bond between the copper surface and the applied gold layer could be observed.

This example clearly shows the positive effect the solution manufactured with the method in accordance with the invention comprising a sulfate free sulfonic acid has on the etch texture when directly compared with Comparative Example 4a. The etch rate was similar, but the residual roughness could be reduced by almost half which resulted in an optically significantly enhanced surface.

It is to be understood that various modifications and substitutions by technical means may be applied to what has been described by way of the examples hereinabove without departing from the scope of the invention as defined by the appended claims. It is further understood that combinations of features described in this application will be suggested to persons skilled in the art and are to be included within the purview of the described invention and within the scope of the appended claims. All publications, patents and patent applications cited herein are hereby incorporated by reference.

## Claims

1. A method of manufacturing a solution for etching copper or a copper alloy, said solution having a pH of 4 or less, said method comprising mixing in water:
a) at least one oxidizing agent selected from the group comprising hydrogen peroxide and peracids and
b) at least one substance selected from the group comprising aromatic sulfonic acids and salts of the aromatic sulfonic acids
wherein said solution has a sulfate ion concentration of less than 0.2 % (w/v),
**characterized in that** the sulfate ion concentration in the at least one substance selected from the group comprising aromatic sulfonic acids and salts of the aromatic sulfonic acids is less than 0.2 % (w/v).

2. The method according to claim 1, **characterized in that** the solution for etching copper or a copper alloy further comprises at least one N-heterocyclic compound.

3. The method according to claim 2, **characterized in that** the concentration of the N-heterocyclic compounds is in the range of from 0.1 to 300 g/l.

4. The method according to any one of claims 2 and 3, **characterized in that** at least one N-heterocyclic compound is selected from the group comprising mono-N, di-N, tri-N and tetra-N heterocyclic compounds.

5. The method according to any one of claims 2-4, **characterized in that** at least one N-heterocyclic compound is selected from the group comprising pyridine, N-methyl pyrrolidone, adenine, guanine, uric acid, imidazole, pyrazole, piperazine, pyrrolidone, pyrroline, triazole, tetrazole and the derivatives thereof.

6. The method according to any one of the preceding claims, **characterized in that** the concentration of the substances is in the range of from 5 to 250 g/l.

7. The method according to any one of the preceding claims, **characterized in that** at least one salt of the aromatic sulfonic acids is selected from the group comprising sodium and potassium salts.

8. The method according to any one of the preceding claims, **characterized in that** the aromatic part of at least one aromatic sulfonic acid or of at least one salt of the aromatic sulfonic acids comprises at least one phenyl group.

9. The method according to claim 8, **characterized in that** at least one phenyl group is substituted by one or more radicals selected from the group comprising nitro, amino, hydroxy, halogen, C₁ - C₅-alkyl radicals and C₁ - C₅-alkoxy radicals.

10. The method according to any one of the preceding claims, **characterized in that** at least one aromatic sulfonic acid is selected from the group comprising benzene sulfonic acid, phenol sulfonic acid, toluene sulfonic acid, amino benzene sulfonic acid and naphthalene sulfonic acid.

11. The method according to any one of the preceding claims, **characterized in that** the solution for etching copper or a copper alloy comprises at least one adjuvant selected from the group comprising polyethylene glycol, polypropylene glycol and the derivatives thereof.

## Patentansprüche

1. Verfahren zur Herstellung einer Lösung zum Ätzen von Kupfer oder einer Kupferlegierung, wobei die Lösung einen pH-Wert von 4 und niedriger hat und wobei das Verfahren umfasst, dass:
a) mindestens ein Oxidationsmittel, ausgewählt aus der Gruppe, umfassend Wasserstoffperoxid und Persäuren, und
b) mindestens ein Stoff, ausgewählt aus der Gruppe, umfassend aromatische Sulfonsäuren und Salze der aromatischen Sulfonsäuren,
in Wasser gemischt werden,
wobei die Lösung eine Sulfationen-Konzentration von weniger als 0,2 % (Gewicht/Volumen) hat,
**dadurch gekennzeichnet, dass** die Sulfationen-Konzentration in dem mindestens einen Stoff, der ausgewählt ist aus der Gruppe, umfassend aromatische Sulfonsäuren und Salze der aromatischen Sulfonsäuren, kleiner als 0,2 % (Gewicht/Volumen) ist.

2. Verfahren nach Anspruch 1, **dadurch gekennzeichnet, dass** die Lösung zum Ätzen von Kupfer oder einer Kupferlegierung weiterhin mindestens eine N-heterocyclische Verbindung enthält.

3. Verfahren nach Anspruch 2, **dadurch gekennzeichnet, dass** die Konzentration der N-heterocyclischen Verbindungen im Bereich von 0,1 bis 300 g/l liegt.

4. Verfahren nach einem der Ansprüche 2 und 3, **dadurch gekennzeichnet, dass** mindestens eine N-heterocyclische Verbindung ausgewählt ist aus der Gruppe, umfassend mono-N-, di-N-, tri-N- und tetra-N-heterocyclische Verbindungen.

5. Verfahren nach einem der Ansprüche 2 - 4, **dadurch gekennzeichnet, dass** mindestens eine N-heterocyclische Verbindung ausgewählt ist aus der Gruppe, umfassend Pyridin, N-Methylpyrrolidon, Adenin, Guanin, Harnsäure, Imidazol, Pyrazol, Piperazin, Pyrrolidon, Pyrrolin, Triazol, Tetrazol und deren Derivate.

6. Verfahren nach einem der vorstehenden Ansprüche, **dadurch gekennzeichnet, dass** die Konzentration der Stoffe im Bereich von 5 - 250 g/l liegt.

7. Verfahren nach einem der vorstehenden Ansprüche, **dadurch gekennzeichnet, dass** mindestens ein Salz der aromatischen Sulfonsäuren ausgewählt ist aus der Gruppe, umfassend Natrium- und Kaliumsalze.

8. Verfahren nach einem der vorstehenden Ansprüche, **dadurch gekennzeichnet, dass** der aromatische Teil mindestens einer aromatischen Sulfonsäure oder mindestens eines Salzes der aromatischen Sulfonsäuren mindestens eine Phenylgruppe enthält.

9. Verfahren nach Anspruch 8, **dadurch gekennzeichnet, dass** mindestens eine Phenylgruppe mit einem oder mehreren Resten substituiert ist, die ausgewählt sind aus der Gruppe, umfassend Nitro, Amino, Hydroxy, Halogen, C₁ - C₅-Alkyl-Reste und C₁ - C₅-Alkoxy-Reste.

10. Verfahren nach einem der vorstehenden Ansprüche, **dadurch gekennzeichnet, dass** mindestens eine aromatische Sulfonsäure ausgewählt ist aus der Gruppe, umfassend Benzolsulfonsäure, Phenolsulfonsäure, Toluolsulfonsäure, Aminobenzolsulfonsäure und Naphthalinsulfonsäure.

11. Verfahren nach einem der vorstehenden Ansprüche, **dadurch gekennzeichnet, dass** die Lösung zum Ätzen von Kupfer oder einer Kupferlegierung mindestens einen Hilfsstoff enthält, der ausgewählt ist aus der Gruppe, umfassend Polyethylenglykol, Polypropylenglykol und deren Derivate.

## Revendications

1. Procédé de fabrication d'une solution destinée à graver du cuivre ou un alliage de cuivre, ladite solution ayant un pH inférieur ou égal à 4, ledit procédé comprenant mélanger dans de l'eau :
a) au moins un agent oxydant choisi dans le groupe comprenant le péroxyde d'hydrogène et les peracides et
b) au moins une substance choisie dans le groupe comprenant les acides sulfoniques aromatiques et les sels des acides sulfoniques aromatiques
dans lequel ladite solution a une concentration en ions sulfate inférieure à 0,2 % (en poids/volume),
**caractérisé en ce que** la concentration en ions sulfate dans l'au moins une substance choisie dans le groupe comprenant les acides sulfoniques aromatiques et les sels des acides sulfoniques aromatiques est inférieure à 0,2 % (en poids/volume).

2. Procédé selon la revendication 1, **caractérisé en ce que** la solution destinée à graver du cuivre ou un alliage de cuivre comprend en outre au moins un composé N-hétérocyclique.

3. Procédé selon la revendication 2, **caractérisé en ce que** la concentration des composés N-hétérocycliques se situe dans la plage de 0,1 à 300 g/l.

4. Procédé selon l'une quelconque des revendications 2 et 3, **caractérisé en ce qu'**au moins un composé N-hétérocyclique est choisi dans le groupe comprenant les composés mono-N, di-N, tri-N et tétra-N hétérocycliques.

5. Procédé selon l'une quelconque des revendications 2 à 4, **caractérisé en ce qu'**au moins un composé N-hétérocyclique est choisi dans le groupe comprenant la pyridine, la N-méthyle pyrrolidone, l'adénine, la guanine, l'acide urique, l'imidazole, le pyrazole, la pipérazine, la pyrrolidone, la pyrroline, le triazole, le tétrazole et leurs dérivés.

6. Procédé selon l'une quelconque des revendications précédentes, **caractérisé en ce que** la concentration des substances se situe dans la plage de 5 à 250 g/l.

7. Procédé selon l'une quelconque des revendications précédentes, **caractérisé en ce qu'**au moins un sel des acides sulfoniques aromatiques est choisi dans le groupe comprenant les sels de sodium et de potassium.

8. Procédé selon l'une quelconque des revendications précédentes, **caractérisé en ce que** la partie aromatique d'au moins un acide sulfonique aromatique ou d'au moins un sel des acides sulfoniques aromatiques comprend au moins un groupe phényle.

9. Procédé selon la revendication 8, **caractérisé en ce qu'**au moins un groupe phényle est remplacé par un ou plusieurs radicaux choisis dans le groupe comprenant les radicaux nitro, amino, hydroxy, halogène, alkyle en C₁-C₅ et les radicaux alcoxy en C₁-C₅.

10. Procédé selon l'une quelconque des revendications précédentes, **caractérisé en ce qu'**au moins un acide sulfonique aromatique est choisi dans le groupe comprenant l'acide benzène sulfonique, l'acide phénol sulfonique, l'acide toluène sulfonique, l'acide amino benzène sulfonique et l'acide naphtalène sulfonique.

11. Procédé selon l'une quelconque des revendications précédentes, **caractérisé en ce que** la solution destinée à graver du cuivre ou un alliage de cuivre comprend au moins un adjuvant choisi dans le groupe comprenant le polyéthylène glycol, le polypropylène glycol et leurs dérivés.
